# EUROPÄISCHE PATENTSCHRIFT

(11) **EP 3 673 554 B1**
(45) Veröffentlichungstag und Bekanntmachung des Hinweises auf die Patenterteilung: **29.09.2021**
(21) Anmeldenummer: 18746840.0
(22) Anmeldetag: 25.07.2018
(51) Int. Cl.: H02J 7/00

(54) **VERFAHREN ZUR BESTIMMUNG DES LADEZUSTANDES EINER ENERGIESPEICHERZELLE UND ENERGIESPEICHERSYSTEM**
METHOD FOR DETERMINING STATE OF CHARGE OF AN ENERGY STORAGE CELL AND ENERGY STORAGE SYSTEM
PROCÉDÉ POUR DÉTERMINER L'ÉTAT DE CHARGE D'UNE CELLULE D'ACCUMULATION D'ÉNERGIE ET SYSTÈME D'ACCUMULATION D'ÉNERGIE

(30) Priorität: 25.08.2017 DE 102017008013
(43) Veröffentlichungstag der Anmeldung: 01.07.2020
(73) Patentinhaber: SEW-EURODRIVE GmbH & Co. KG, 76646 Bruchsal (DE)
(72) Erfinder: SCHMIDT, Josef, 76676 Graben-Neudorf (DE); ZÖLLER, Thomas, 76646 Bruchsal (DE); SCHÄFER, Jens, 76676 Graben-Neudorf (DE); SCHUMANN, Christian, 76774 Leimersheim (DE); HAUCK, Matthias, 68723 Schwetzingen (DE)
(86) Internationale Anmeldenummer: PCT/EP2018/025204
(87) Internationale Veröffentlichungsnummer: WO 2019/037892

(56) Entgegenhaltungen:
- EP-A1- 1 384 086
- EP-A1- 1 384 086
- EP-A1- 2 848 953
- EP-A1- 2 848 953
- CN-A- 105 676 134
- DE-A1-102013 203 809
- DE-A1-102013 203 809
- US-A1- 2010 121 591
- US-A1- 2010 121 591
- US-A1- 2013 271 148
- US-A1- 2014 365 150
- US-A1- 2014 365 150

## Beschreibung

Die Erfindung betrifft ein Verfahren zur Bestimmung des Ladezustandes einer Energiespeicherzelle und ein Energiespeichersystem.

Als Energiespeicherzellen sind beispielsweise Akkumulatoren bekannt. Allerdings ist insbesondere bei nicht vollständigen Entladungen und Aufladungen der Ladezustand nicht in ausreichender Qualität bestimmbar.

**Aus der** DE 10 2012 200 414 A1 **ist als nächstkommender Stand der Technik ein Verfahren zur Bestimmung eines Ladezustandes eines elektrischen Energiespeichers bekannt.**

**Aus der** EP 1 384 086 A1 **ist als nächstkommender Stand der Technik ein Verfahren zur Bestimmung der Batterieladung bekannt.**

**Aus der** EP 2 848 953 A1 **ist ein Verfahren zum Schätzen des Ladungszustands einer sekundären Zelle bekannt.**

**Aus der** DE 10 2013 203 809 A1 **ist ein Verfahren zum Bestimmen einer elektrischen Kapazität einer Energiespeichereinheit bekannt.**

**Aus der** US 2010 / 121 591 A1 **ist ein Verfahren zum Detektieren des Ladezustandes einer Batterie bekannt.**

**Aus der** US 2014 / 365 150 A1 **ist ein Verfahren zum Bestimmen des Ladungszustands einer elektrischen Energiespeichervorrichtung bekannt.**

Der Erfindung liegt daher die Aufgabe zugrunde, eine einfache und sichere Bestimmung des Ladezustands einer Energiespeicherzelle weiterzubilden.

Erfindungsgemäß wird die Aufgabe bei dem Verfahren nach den in Anspruch 1 und bei dem Energiespeichersystem nach den in Anspruch 12 angegebenen Merkmalen gelöst.

Wichtige Merkmale der Erfindung bei dem Verfahren sind, dass das Verfahren zur Bestimmung des Ladezustandes einer Energiespeicherzelle, insbesondere eines elektrochemischen Energiespeichers vorgesehen ist,
wobei die an der Energiespeicherzelle anliegende Spannung und der von der Energiespeicherzelle gelieferte oder aufgenommene Strom, erfasst werden,
wobei in einem ersten Verfahrensschritt eine Wertetabelle, insbesondere Kennlinienfeld, erstellt wird, welches einer inneren Zellspannung und einem ladungsbezogenen Spannungsgradienten einen Ladezustand zuordnet,
wobei danach in einem zweiten Verfahrensschritt aus der jeweils aktuell bestimmten inneren Zellspannung und dem jeweils aktuell bestimmten ladungsbezogenen Spannungsgradienten ein Ladezustand mittels der Wertetabelle, insbesondere Kennlinienfeld, zugeordnet wird.

Von Vorteil ist dabei, dass durch die Bestimmung der inneren Zellenspannung und des ladungsbezogenen Spannungsgradienten der Ladezustand schnell und einfach, nämlich mittels Wertetabellen bestimmbar ist. Somit ist nur der Stromverlauf zu erfassen und die jeweils aktuelle Spannung. Somit ist ein geringer Aufwand notwendig. Selbst wenn die Auflade- und Entladezyklen im Normalbetrieb, also im zweiten Verfahrensschritt keine vollständigen Aufladungen oder Entladungen beinhalten, ist eine genaue Bestimmung des Ladezustands in einfacher Weise ermöglicht.

Erfindungsgemäß werden die erfassten Werte des Stromes der Zelle einem Integrierglied zugeführt, aus dessen **Ausgangssignal** Q_Zähler **ein ladungsdiskretes Abtastsignal d_q** erzeugt wird, insbesondere mittels eines einen Modulowert bestimmenden Rechnerglieds und/oder insbesondere wobei die Diskretisierung q_a beträgt. Von Vorteil ist dabei, dass in einfacher Weise ein Taktsignal für die Berechnungsglieder zur Verfügung stellbar ist. Im Unterschied zu dem sonst üblichen zeitlichen Taktsignal wird nur dann ein jeweiliger Takt, also Flankenwechsel des Taktsignals, erzeugt, wenn mittels Stromentnahme oder Stromzuführung die Ladung sich um einen Mindestwert ändert.

Erfindungsgemäß wird vom ladungsdiskreten Abtastsignal gesteuert der Wert der an der Zelle anliegenden Spannung erfasst und einem ersten Halteglied zugeführt, von dessen Ausgangssignal das Ausgangssignal eines Proportionalglieds subtrahiert wird **zur Bestimmung der inneren Zellspannung u_i,q,**
wobei vom ladungsdiskreten Abtastsignal gesteuert der Wert des Stromes der Zelle, insbesondere der Wert des von der Energiespeicherzelle gelieferten oder aufgenommenen Stromes, erfasst wird und einem zweiten Halteglied zugeführt wird, dessen Ausgangssignal dem Proportionalglied als Eingangssignal zugeführt wird,
insbesondere wobei der Proportionalwert des Proportionalgliedes ein den Innenwiderstand der Zelle darstellender Parameter ist. Von Vorteil ist dabei, dass eine einfache Bestimmung der inneren Zellspannung ermöglicht ist.

Bei einer vorteilhaften Ausgestaltung wird der Wert der inneren Zellspannung u_i,q als Eingangssignal einem vom ladungsdiskreten Abtastsignal gesteuerten Totzeitglied zugeführt, dessen Totzeit ein Ladungsänderungsbetrag q_1 ist,
wobei dem Ausgangssignal des Totzeitglieds der jeweils Wert der inneren Zellspannung u_i,q subtrahiert wird und die so gebildete Differenz einem weiteren Proportionalglied als Eingangssignal zugeführt wird, wobei das Ausgangssignal des Proportionalglieds einem Verzögerungsglied, insbesondere einem Verzögerungsglied erster Ordnung, zugeführt wird, dessen Ausgangssignal den **ladungsbezogenen Spannungsgradienten u_grad,q** darstellt, insbesondere wobei der Proportionalwert des weiteren Proportionalglieds der Kehrwert des Ladungsänderungsbetrags q_1 ist,
insbesondere so dass der dem Totzeitglied zugeführte Wert der inneren Zellspannung u_i,q erst bei einer Änderung des Ausgangssignal Q_Zähler des Integrierglieds um mindestens den Ladungsänderungsbetrag q_1 als Ausgangssignal weitergeleitet wird,
wobei der Ladungsänderungsbetrag q_1 größer als die Diskretisierung q_a ist, insbesondere aber mindestens hundertmal kleiner als die Nennladekapazität der Zelle. Von Vorteil ist dabei, dass eine ladungsbezogene partielle Differenzierung ausgeführt wird, so dass eine physikalische Größe einfach bestimmbar ist, welche zusammen mit der inneren Zellspannung charakteristisch ist für den Ladezustand der Zelle.

Bei einer vorteilhaften Ausgestaltung sind das erste und zweite Halteglied vom ladungsdiskreten Abtastsignal gesteuert, so dass der jeweils gehaltene Wert jeweils gehalten wird, bis das Ausgangssignal Q_Zähler des Integrierglieds sich um mindestens eine Diskretisierungsstufe ändert. Von Vorteil ist dabei, dass nur bei Änderung des Ladezustands ein neuer Wert gehalten wird. Die Halteglieder arbeiten also nicht zeitgetaktet, sondern vom ladungsbezogenen Abtastsignal getaktet. Wenn also der Zelle eine lange Zeit kein Strom entnommen oder zugeführt wird, wird der Wert entsprechend gehalten.

Bei einer vorteilhaften Ausgestaltung wird die erfassten Werte des Stromes der Zelle integriert und aus dem **Ausgangssignal Q_Zähler,** also dem Integrationsergebnis, ein Taktsignal, also **ein ladungsdiskretes Abtastsignal d_q** erzeugt. Von Vorteil ist dabei, dass die Bestimmung durch die Ladezustandsänderung getaktet ist. Somit bleibt der Ladungswert konstant, wenn der Zelle kein Strom zugeführt oder entnommen wird.

Bei einer vorteilhaften Ausgestaltung stellt **die innere Zellspannung u_i,q** als Differenz zwischen der erfassten Spannung und dem Produkt aus einem Parameter, welcher den Innenwiderstand der Zelle dar, und dem Wert des erfassten Stroms bestimmt. Von Vorteil ist dabei, dass eine einfache Bestimmung der inneren Zellspannung ausführbar ist.

Bei einer vorteilhaften Ausgestaltung wird **der ladungsbezogene Spannungsgradient u_grad,q** durch partielle Differentiation des Werteverlaufs der inneren Zellspannung u_i,q gebildet. Von Vorteil ist dabei, dass der Spannungsgradient einfach bestimmbar ist, mit dem Spannungsgradient der Ladezustand einfach bestimmbar ist und der Spannungsgradient sich nur ändert bei Änderung des Ladezustands, also Stromentnahme oder Stromzufuhr.

Bei einer vorteilhaften Ausgestaltung wird im ersten Verfahrensschritt die Zelle ausgehend von verschiedenen Anfangsladezuständen jeweils entladen und dabei werden zu jedem Ladewert die innere Zellspannung und der ladungsbezogene Spannungsgradient bestimmt,
insbesondere so, dass jeweilige Dreiertupel bestimmt werden, wobei jedes Dreiertupel einen Ladewert, einen Wert der inneren Zellspannung und einen Wert des ladungsbezogenen Spannungsgradienten aufweist,
insbesondere wobei der Ladewert bestimmt wird, indem vom Anfangsladezustand das Ausgangssignal Q_Zähler subtrahiert wird. Von Vorteil ist dabei, dass eine einfache Bestimmung eines Kennlinienfeldes ausführbar ist.

Bei einer vorteilhaften Ausgestaltung werden die Dreiertupel abhängig von ihrem Wert der inneren Zellspannung in Spannungsintervalle sortiert und nach dem Sortieren für jedes Spannungsintervall eine Interpolationsfunktion bestimmt, welche einem Wert des ladungsbezogenen Spannungsgradienten einen Ladungswert zuordnet. Von Vorteil ist dabei, dass mittels der Sortierung in Spannungsintervalle eine Diskretisierung in einfacher Weise ausführbar ist. Außerdem ist durch die Intervallbreite die Genauigkeit vorgebbar.

Bei einer vorteilhaften Ausgestaltung wird mittels zweidimensionaler Interpolation eine Interpolationsfunktion bestimmt, welche einem Wertepaar, bestehend aus einem Wert des ladungsbezogenen Spannungsgradienten und einem Wert der inneren Zellspannung, einen Ladungswert zuordnet. Von Vorteil ist dabei, dass eine einfache Bestimmung ermöglicht wird, da nur zwei Werte jeden Ladungswert bestimmbar machen.

Bei einer vorteilhaften Ausgestaltung werden nach dem Bestimmen der jeweiligen Interpolationsfunktion Stützpunkte der Interpolationsfunktion bestimmt, so dass aus den Stützpunkten eine Wertetabelle gebildet ist. Von Vorteil ist dabei, dass Speicherplatz einsparbar ist.

Bei einer vorteilhaften Ausgestaltung werden im zweiten Verfahrensschritt Zwischenwerte durch Interpolation, insbesondere lineare Interpolation, bestimmt. Von Vorteil ist dabei, dass Zwischenwerte in einfacher Weise und mit genügender Genauigkeit errechenbar sind. Denn je mehr Zwischenwerte verwendet werden, desto höher ist die Genauigkeit bei der Bestimmung.

Bei einer vorteilhaften Ausgestaltung werden die Dreiertupel abhängig von ihrem Ladungswert in verschiedene Gruppen einsortiert, wobei jeder Gruppe ein jeweiliger Bereich von Ladungswerten zugordnet ist,
wobei die Bereiche einander nicht überlappen,
wobei für jede Gruppe eine Interpolation ausgeführt wird, daraus Stützpunkte bestimmt werden und somit eine jeweilige Wertetabelle für jede Gruppe bestimmt wird,
wobei im zweiten Verfahrensschritt die zur Bestimmung des Ladezustands auszuwählende Wertetabelle nach einem Entscheidungskriterium ausgewählt wird. Von Vorteil ist dabei, dass aus den mit den verschiedenen Wertetabellen bestimmten, verschiedenen Ladezustandswerten der am besten passende auswählbar ist.

Bei einer vorteilhaften Ausgestaltung ist das Entscheidungskriterium, ob die aktuell bestimmte innere Zellspannung u_i,q unter einem vorgegebenen Schwellwert liegt, insbesondere bei welchem unabhängig vom Ladezustand eine eindeutige Zuordnung zwischen dem Spannungsgradienten U_grad,q und dem Ladungszustand Q_ist besteht,
- oder das Entscheidungskriterium ist, dass mit allen Wertetabellen Ladewerte bestimmt werden und beim Auswählen des Ladewerts als aktuellen Ladungszustand das Entscheidungskriterium ist, die betragsmäßig kleinste Abweichung zwischen dem aktuellen Schätzwert Q_Schätzer und dem jeweiligen Interpolationswert,
- oder das Entscheidungskriterium ist, ob die Abweichung zwischen dem aktuellen Schätzwert Q_Schätzer und den Interpolationswerten einen vorgegebenen Schwellwert überschreitet, wobei in diesem Fall die Summe aus Stützwert Q_Stützung und Q_Zähler ausgegeben wird.

Von Vorteil ist dabei, dass einfache Entscheidungskriterien vorgebbar sind.

Wichtige Merkmale bei dem Energiespeichersystem sind, dass das Energiespeichersystem eine Energiespeicherzelle und eine Signalelektronik mit einem Mittel zur Erfassung der an der Zelle anliegenden Spannung und zur Erfassung des Stromes der Zelle aufweist,
wobei die Signalelektronik geeignet ausgeführt ist zur Durchführung des vorbeschriebenen Verfahrens.
Von Vorteil ist dabei, dass mit denselben Vorrichtungsartigen Mitteln einerseits die Kennlinienfelder, also Wertetabellen, bestimmbar sind und andererseits im Normalbetrieb die Bestimmung des Ladezustandes unter Verwendung der Wertetabellen ausführbar ist.

Weitere Vorteile ergeben sich aus den Unteransprüchen. Die Erfindung ist nicht auf die Merkmalskombination der Ansprüche beschränkt.

Die Erfindung wird nun anhand von schematischen Abbildungen näher erläutert:
In der Figur 1 ist die Bestimmung eines ladungsdiskreten Abtastsignals und eines Spanungsgradienten einer erfindungsgemäßen Energiespeicherzelle dargestellt.
In der Figur 2 ist die Bestimmung einer Wertetabelle gezeigt, welche die Ladung als Funktion des Spannungsgradienten beinhaltet.
In der Figur 3 ist die Bestimmung einer Wertetabelle gezeigt, welche die Ladung als Funktion des Spannungsgradienten und der inneren Zellenspannung beinhaltet.
In der Figur 4 ist im Unterschied zur Figur 3 ein zweidimensionales Interpolationsverfahren bei der Bestimmung verwendet.
In der Figur 5 ist ein Verfahren zur Bestimmung des geschätzten Ladezustandes der Zelle schematisch skizziert, wobei Figur 4 verwendet wird.
In der Figur 6 ist ein im Vergleich zu Figur 4 verbessertes Verfahren dargestellt.
In der Figur 7 ist ein Verfahren zur Bestimmung des geschätzten Ladezustandes der Zelle schematisch skizziert, wobei Figur 6 verwendet wird.

Wie in den Figuren dargestellt wird erfindungsgemäß der Ladezustand einer Energiespeicherzelle abgeschätzt. Die erfindungsgemäße Energiespeicherzelle ist beispielsweise als Batterie, Akkumulator oder anderer elektrochemischer Energiespeicher ausgeführt.

Das erfindungsgemäße Verfahren weist zunächst Verfahrensschritte auf, welche zur Bestimmung einer Wertetabelle dienen. In nachfolgenden Verfahrensschritten wird mit Hilfe dieser so bestimmten Wertetabelle der Ladungszustand geschätzt.

Für die Wertetabellen und für das erfindungsgemäße Verfahren ist der Spannungsgradient U_grad,q wesentlich. Denn abhängig vom Ladezustand liegt einerseits eine innere Zellenspannung vor und andererseits nimmt diese innere Zellenspannung bei abnehmender Ladung ab. Die spezifische Spannungsänderung bei abnehmender Ladung, insbesondere also der Quotient aus Spannungsdifferenz und Ladungsdifferenz zwischen zwei wenig unterschiedlichen Ladungszuständen wird als Spannungsgradient bezeichnet.

Zur Bestimmung der inneren Zellenspannung U_i,q ist der Innenwiderstand R_Zelle zu berücksichtigen. Somit wird die inneren Zellenspannung U_i,q aus der an der Zelle erfassten Spannung U_i bestimmt, indem das Produkt aus dem Innenwiderstand R_Zelle und dem erfassten Wert des Stromes der Zelle abgezogen wird von dem Wert der an der Zelle erfassten Spannung U_i.

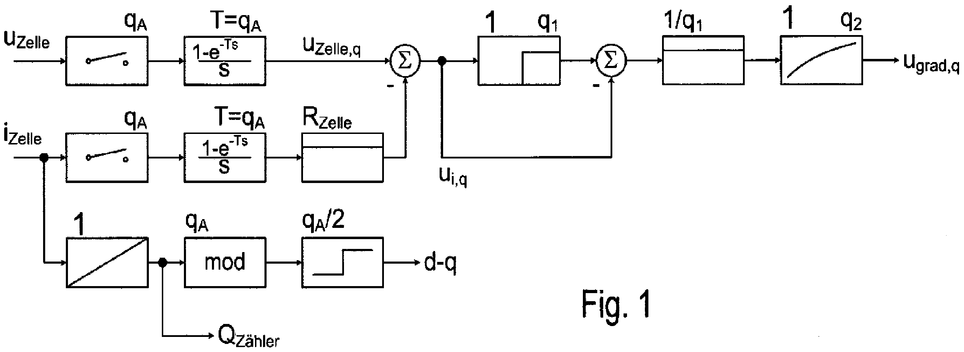

Wie in Figur 1 schematisch dargestellt, wird das gesamte Verfahren der Bestimmung in Abhängigkeit von dem ladungsdiskreten Abtastsignal ausgeführt, also nicht zeitgesteuert, sondern abhängig von der Ladungszustandsänderung.

Zur Bestimmung des ladungsdiskreten Abtastsignals wird der erfasste Stromwert einem zeitlichen Integrierglied zugeführt, dessen Ausgangssignal Q_Zähler im Wesentlichen dem zeitlichen Integralwert des erfassten Stromwerteverlaufs entspricht.

Aus diesem Ausgangssignal des Integrierglieds wird das ladungsdiskrete Abtastsignal bestimmt. Hierzu wird das Ausgangssignal des Integrierglieds einem Modulo-Wert bildenden Glied zugeführt, dessen Ausgangssignal als das ladungsdiskrete Abtastsignal entspricht.

Dieses Signal wird verwendet, um ein Abtastglied anzusteuern, mit dessen Hilfe der an der Zelle erfasste Wert der Spannung U_i einem Halteglied zugeführt wird, dessen Ausgangssignal die Zellenspannung U_Zelle,q ist. Somit wird bei jeder diskreten Änderung des Ladezustands Q-Zähler das Abtastglied angesteuert, um den aktuell erfassten Wert der Spannung dem Halteglied zuzuführen

Ebenso wird bei jeder diskreten Änderung des Ladezustands Q-Zähler ein weiteres Abtastglied angesteuert, um den aktuell erfassten Wert des Stromes einem weiteren Halteglied zuzuführen, dessen Ausgangssignal mit dem Wert R_Zelle des Innenwiderstands der Zelle multipliziert wird und das Ergebnis subtrahiert wird vom obengenannten Ausgangssignal die Zellenspannung U_Zelle,q. Der so bestimmte Wert der inneren Zellenspannung u_i,q wird einem Totzeitglied zugeführt, wobei als Zeit wiederum das ladungsdiskrete Abtastsignal verwendet wird. Die Diskretisierung dieses Abtastsignals ist mit q_a bezeichnet. Das Totzeitglied weist die Totzeit q_1 auf, welche größer ist als q_a und zumindest hundertmal kleiner als der Nennwert q_N der Ladung der Zelle. Die Totzeit q_1 ist also auch ein ladungsbezogener Wert.

Vom Ausgangssignal des Totzeitglieds wird der aktuelle Wert der inneren Zellenspannung u_i,q subtrahiert und die so bestimmte Differenz dividiert durch den Wert der Totzeit q_1, so dass auf diese Weise der der Wert des Spannungsgradienten U_grad,q bestimmt ist.

Der Spannungsgradient U_grad,q ist also ein Maß für die Größe des Spannungsabfalls bezogen auf die umgesetzte, insbesondere gespeicherte, Ladungsmenge.

Zur Bestimmung eines Kennlinienfelds, also zur Bestimmung einer Wertetabelle, welche jedem Wertepaar, bestehend aus U_grad,q und u_i,q, einen Ladungszustand Q_ist zuordnet, wird die Zelle ausgehend von einer Vielzahl von Anfangsladezuständen der Zelle entladen. Dabei wird in der oben beschriebenen Weise U_grad,q und u_i,q bestimmt sowie der Ladezustand Q_ist aus dem Anfangsladezustand abzüglich dem Ausgangssignal Q_Zähler des Integrierglieds.

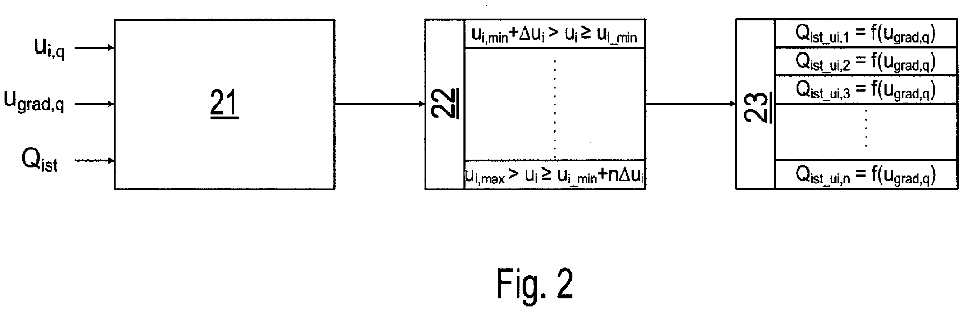

Figur 2 symbolisiert die weiteren Verfahrensschritte zur Bestimmung einer Wertetabelle.

Die bestimmten Dreiertupel (U_grad,q , u_i,q, Q_ist) werden - wie in Figur 2, Bezugszeichen 22 dargestellt - gemäß ihrem Wert u_i,q sortiert, der allerdings in Stufen ΔU diskretisiert wird, wie in Figur 2, Bezugszeichen 21, dargestellt. Dies bedeutet, dass der bestimmte Wert u_i,q diskretisiert wird, also jeweils jeweiligen Spannungsintervallen zugeordnet wird, deren Intervallbreite jeweils ΔU ist. Auf diese Weise wird jedem Intervall, welchem einer der Werte u_i,q zugeordnet ist, auch dessen zugehöriges Wertepaar (U_grad,q, Q_ist) zugeordnet.

Da möglichst viele Dreiertupel verwendet werden, treten in Spannungsintervallen viele solche Wertepaare auf, so dass eine Interpolation 23 ausführbar ist. Dies bedeutet, dass für jedes Stufenintervall, welchem Wertepaare (U_grad,q, Q_ist) zugeordnet sind, eine interpolierende Kurve, also eine Interpolationsfunktion, erstellt wird. Vorzugsweise wird hierbei eine Splineinterpolation angewendet, so dass die Summe der Quadrate des Betrags der Abweichung von der Kurve minimiert ist.

Da die Interpolationsfunktion jedem Wert des Spannungsgradienten U_grad,q einen Wert Q_ist zuordnet, ist somit durch Bestimmung von u_i,q und dadurch des Spannungsintervalls und darüber hinaus durch Bestimmung des Spannungsgradienten U_grad,q auch ein Wert Q_ist bestimmbar.

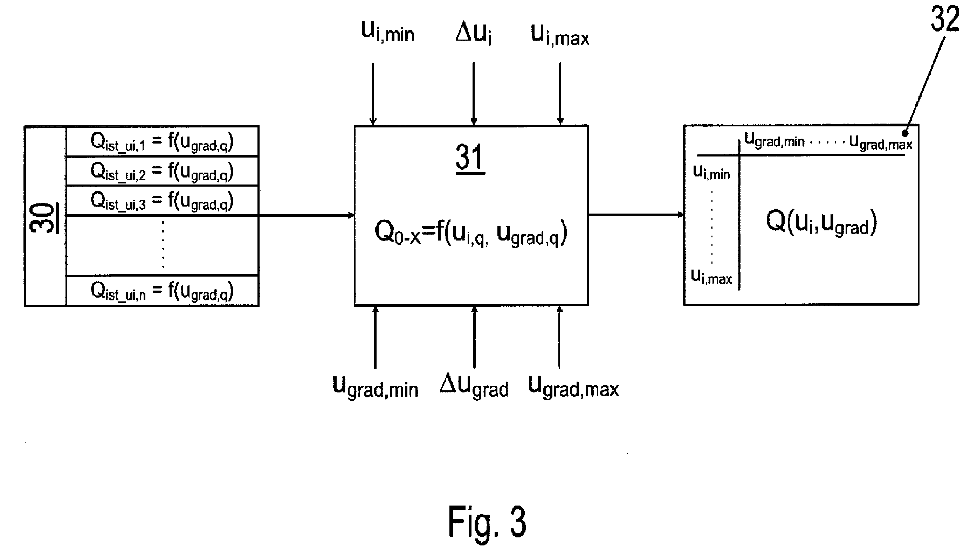

Wie in Figur 3 dargestellt, wird aus der Menge der bestimmten Interpolationsfunktionen, die im Block 30 symbolisiert sind, eine Wertetabelle 32 bestimmt, indem zunächst Stützpunkte bestimmt werden, wie in dem zwischengeordneten Block 31 symbolisiert ist.

Hierzu werden also mittels der Interpolationsfunktionen Stützpunkte bestimmt. Jeder Stützpunkt ordnet einem Wertepaar aus diskretisierter innerer Zellenspannung u_i, die zwischen einem Minimalspannungswert U_i,min und einem Maximalspannungswert U_i,max mit der Intervallbreite, also Stufenweite, ΔU_i diskretisiert ist, und aus diskretisiertem Spannungsgradienten U_grad,q, der zwischen einem Minimalwert U_grad,min und einem Maximalwert U_grad,max mit der Intervallbreite, also Stufenweite, ΔU_grad diskretisiert ist, einen Ladungswert Q zu.

Auf diese Weise ist eine Wertetabelle, also die Stützpunkte im Speicher abspeicherbar, ohne dass ein großer Speicherplatzbedarf vorhanden wäre. Somit sind bei Vorgabe eines Wertes des Spannungsgradienten U_grad und eines Wertes der Zellspannung U_i ein jeweils zugeordneter Ladungswert Q bestimmbar, wobei Zwischenwerte mittels linearer Interpolation errechnet werden.

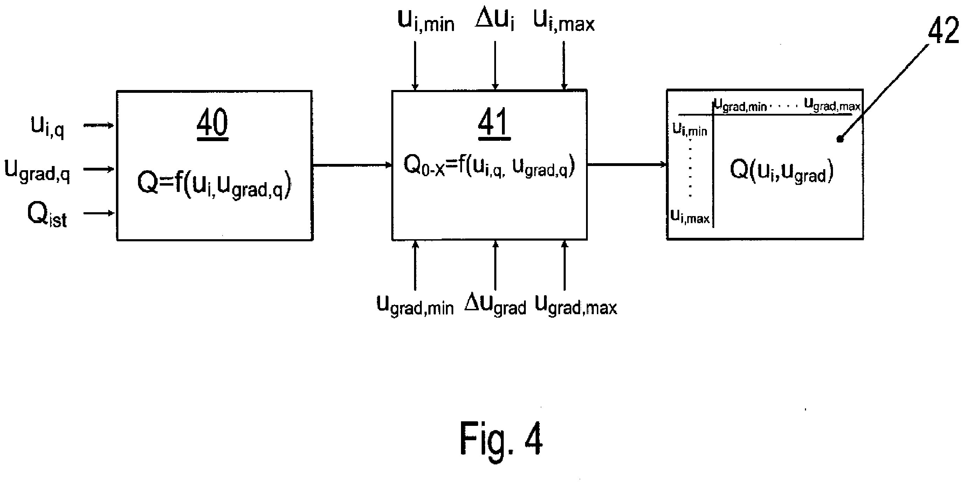

Wie in Figur 4 dargestellt, ist bei einem alternativen Bestimmungsverfahren eine zweidimensionale Interpolation anwendbar und somit ein einfaches Bestimmen ermöglicht.

Bei der zweidimensionalen Interpolation 40 wird eine zweidimensionale Fläche als Funktion von innerer Zellspannung U_i,q und Spannungsgradient U_grad bestimmt. Vorzugsweise ist die Fläche dabei derart gewählt, dass die Summe der Quadrate der Abstandsbeträge aller Dreiertupel zur Fläche minimal wird.

Aus der so mittels Interpolation 40 bestimmten Fläche werden wiederum Stützpunkte bestimmt, wie im Block 41 in Figur 4 symbolisiert ist. Dabei wird wiederum für die innere Zellenspannung u i eine Diskretisierung mit der Intervallbreite, also Stufenweite, ΔU_i zwischen einem Minimalspannungswert U:i:min und einem Maximalspannungswert U_i_max ausgeführt. Für den Spannungsgradienten U_grad,q wird zwischen einem Minimalwert U_grad,min und einem Maximalwert U_grad,max mit der Intervallbreite, also Stufenweite, ΔU_grad diskretisiert. Auf diese Weise entsteht eine Wertetabelle 42 aus Stützpunkten.

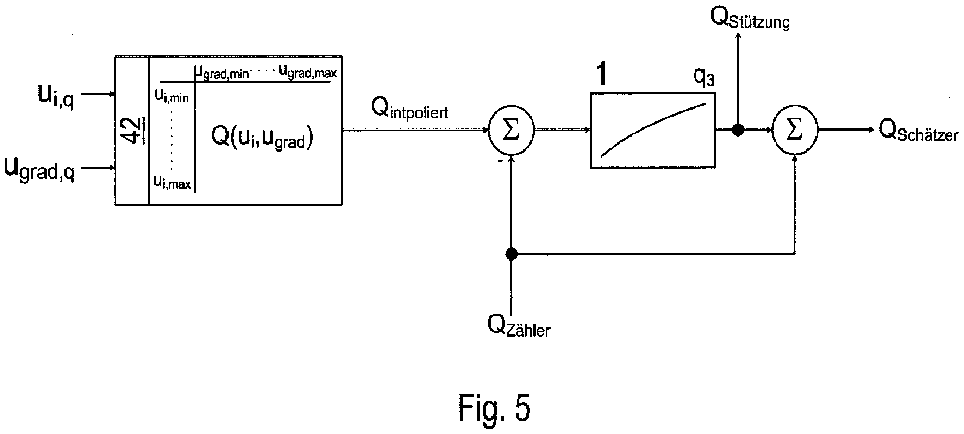

Wie in Figur 5 gezeigt, wird mit der so bestimmten Wertetabelle 42 aktuell bestimmter innerer Zellenspannung u_i,q und aktuell bestimmtem Spannungsgradienten U_grad,q die Bestimmung eines Ladungszustandes Q ausgeführt. Dabei werden Zwischenwerte zwischen den Stützpunkten durch lineare Interpolation bestimmt. In Figur 5 ist daher der Ergebniswert dieser Bestimmung als Q_interpoliert bezeichnet worden.

Von diesem Wert Q_interpoliert wird der aktuell bestimmte Wert Q_Zähler subtrahiert und die so bestimmte Differenz einem Verzögerungsglied, insbesondere einem Verzögerungsglied erster Ordnung, zugeführt, dessen Zeitkonstante hier nun ein Ladungswert q_3 ist. Dem Ausgangssignal Q_Stützung des Verzögerungsglieds wird der aktuell bestimmte Wert Q_Zähler aufaddiert und somit der Schätzwert für den Ladezustand Q_Schätzer bestimmt.

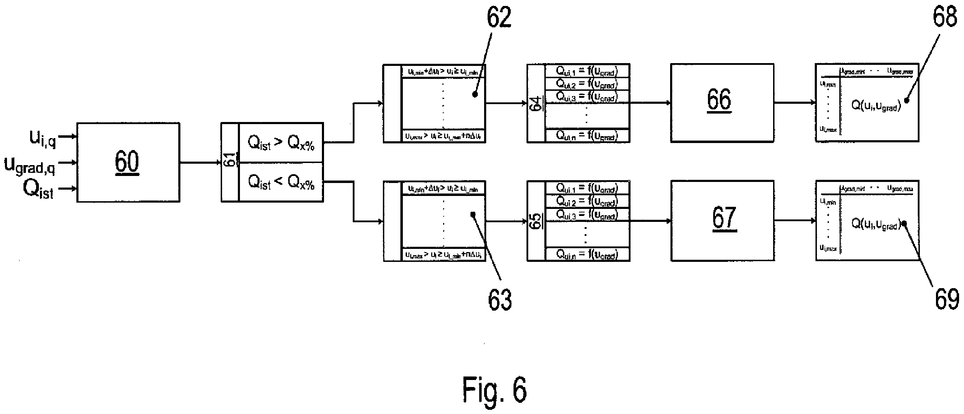

Wie in Figur 6 gezeigt, wird bei einer alternativen Ausführung eine verbesserte Bestimmung ermöglicht, wenn die funktionale Abhängigkeit des Ladungszustands Q vom Spannungsgradienten U_grad,q kein eineindeutiger Zusammenhang ist.

Hierbei werden nach der Diskretisierung 60 der inneren Zellenspannung u_i diejenigen Dreiertupel (U_grad,q , u_i,q, Q_ist), deren Ladungswert Q_ist über einem vorgegebenen Wert Q_x liegt, separiert von den anderen DreiertupeIn (U_grad,q , u_i,q, Q_ist). Die beiden so gebildeten, verschiedenen Mengen von Dreiertupeln werden dann jeweils einer Sortierung (62, 63) mit Spannungsdiskretisierung jeweils gemäß Figur 2 unterzogen. Danach wird jeweils eine Interpolation (64, 65) ausgeführt jeweils gemäß Figur 2 und dann die Bestimmung der Stützpunkte (66, 67) ausgeführt. Daraus werden dann die Wertetabellen (68, 69) erstellt.

Somit ist dann der Ladungszustand Q bestimmbar, indem die jeweils zuständige Tabelle verwendet wird.

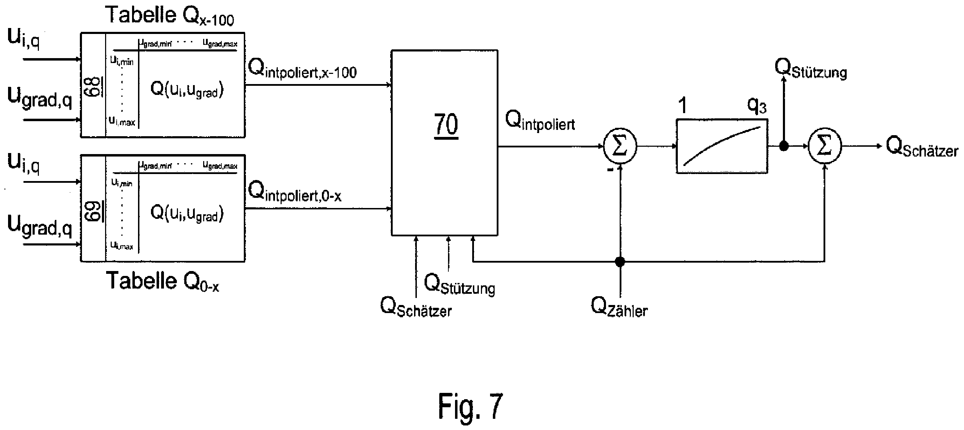

Diese Bestimmung des jeweils aktuellen Ladezustands gemäß den Wertetabellen ist in Figur 7 näher dargestellt.

Denn aus einem aktuell bestimmten inneren Zellspannungswert u_i,q und einem aktuell bestimmten Spannungsgradienten U_grad,q wird mittels der Wertetabelle 68 ein erster Ladezustandswert Q_interpoliert,x-100 und aus der anderen Wertetabelle 69 ein zweiter Ladezustandswert Q_interpoliert,0-x bestimmt. Diese beiden Werte werden einem Mittel 70 zur Bewertung und Auswahl zugeführt, welcher der beiden Werte dem wirklichen Ladezustand am besten entspricht.

Hierzu wird eines der folgenden Kriterien angewendet:
1. Falls die aktuell bestimmte Spannung u_i,q unter einem vorgegebenen Schwellwert liegt, bei welchem unabhängig vom Ladezustand eine eindeutige Zuordnung zwischen dem Spannungsgradienten U_grad,q und dem Ladungszustand Q_ist besteht, ist der Wert Q_interpoliert,x aus Wertetabelle 69 zu wählen. Andernfalls wird Q_interpoliert,x-100 gewählt.
2. In Abhängigkeit der Größe der Abweichung zwischen dem aktuellen Schätzwert Q_Schätzer und dem jeweiligen Interpolationswert wird der Interpolationswert für die weitere Auswertung gewählt, der die betragsmäßig kleinste Abweichung aufweist.
3. Überschreitet die Abweichung zwischen dem aktuellen Schätzwert Q_Schätzer und den Interpolationswerten einen vorgegebenen Schwellwert wird die Summe aus Stützwert Q_Stützung und Q_Zähler ausgegeben. Somit verändert sich der Schätzwert nur noch auf Basis des Zählwertes.

Bei weiteren erfindungsgemäßen Ausführungsbeispielen werden nicht nur zwei Mengen gebildet, sondern eine größere Anzahl vor Mengen, in welche die jeweiligen Dreiertupel eingeordnet werden. Das Verfahren zur Bestimmung des Ladungszustandes wird dann in der Figur 6 und Figur 7 entsprechender Weise ausgeführt. In Weiterbildung besteht die Möglichkeit, in weiteren Dreiertupeln verschiedene Temperaturbereiche abzudecken, falls die Zelle hier Abhängigkeiten aufweist.

### Bezugszeichenliste

U_Zelle Zellspannung
I_Zelle Zellstrom
R_Zelle Innenwiderstand der Zelle
U_i,q Innere Zellenspannung
Q1 Ladungskonstante
D_q ladungsdiskretes Abtastsignal
U_grad,q ladungsabhängiger Spannungsgradient
q_A Diskretisierung der Ladungszustandsänderung

21 Diskretisierung
22 Sortierung
23 Interpolation
30 Interpolation
31 Berechnung der Stützpunkte
32 Wertetabelle
40 Interpolation
41 Berechnung der Stützpunkte
42 Wertetabelle
60 Diskretisierung
61 Sortierung
62 Sortierung in Gruppen
63 Sortierung in Gruppen
63 Interpolation
64 Interpolation
65 Interpolation
66 Berechnung der Stützpunkte
67 Berechnung der Stützpunkte
68 Wertetabelle
69 Wertetabelle
70 Mittel zur Bewertung und Auswahl

## Patentansprüche

1. Verfahren zur Bestimmung des Ladezustandes einer Energiespeicherzelle, insbesondere eines elektrochemischen Energiespeichers,
**wobei die an der Energiespeicherzelle anliegende Spannung (U_Zelle) und der von der Energiespeicherzelle gelieferte oder aufgenommene Strom (I_Zelle) erfasst werden,**
**dadurch gekennzeichnet, dass**
in einem ersten Verfahrensschritt eine Wertetabelle (42), insbesondere Kennlinienfeld, erstellt wird, welches einer inneren Zellspannung und einem **auf Basis der inneren Zellspannung (u_i,q) berechneten** ladungsbezogenen Spannungsgradienten einen Ladezustand zuordnet,
wobei zeitlich nach dem ersten Verfahrensschritt in einem zweiten Verfahrensschritt aus der jeweils aktuell bestimmten inneren Zellspannung und dem jeweils aktuell bestimmten ladungsbezogenen Spannungsgradienten ein Ladezustand mittels der Wertetabelle (42), insbesondere Kennlinienfeld, zugeordnet wird,
**wobei die erfassten Werte des Stromes der Zelle einem Integrierglied zugeführt werden, aus dessen Ausgangssignal (Q_Zähler) ein ladungsdiskretes Abtastsignal (d_q) erzeugt wird, insbesondere mittels eines einen Modulowert bestimmenden Rechnerglieds,**
**wobei vom ladungsdiskreten Abtastsignal gesteuert der Wert der an der Zelle anliegenden Spannung erfasst wird und einem ersten Halteglied zugeführt wird, von dessen Ausgangssignal das Ausgangssignal eines Proportionalglieds subtrahiert wird zur Bestimmung der inneren Zellspannung (u_i,q),**
**wobei vom ladungsdiskreten Abtastsignal gesteuert der Wert des von der Energiespeicherzelle gelieferten oder aufgenommenen Stromes der Zelle erfasst wird und einem zweiten Halteglied zugeführt wird, dessen Ausgangssignal dem Proportionalglied als Eingangssignal zugeführt wird.**

2. Verfahren nach Anspruch 1,
**dadurch gekennzeichnet, dass**
**der Proportionalwert des Proportionalgliedes ein den Innenwiderstand der Zelle darstellender Parameter ist.**

3. Verfahren nach einem der vorhergehenden Ansprüche,
**dadurch gekennzeichnet, dass**
der Wert der inneren Zellspannung (u_i,q) als Eingangssignal einem vom ladungsdiskreten Abtastsignal gesteuerten Totzeitglied zugeführt wird, dessen Totzeit ein Ladungsänderungsbetrag (q_1) ist,
wobei dem Ausgangssignal des Totzeitglieds der jeweils Wert der inneren Zellspannung (u_i,q) subtrahiert wird und die so gebildete Differenz einem weiteren Proportionalglied als Eingangssignal zugeführt wird, wobei das Ausgangssignal des Proportionalglieds einem Verzögerungsglied, insbesondere einem Verzögerungsglied erster Ordnung, zugeführt wird, dessen Ausgangssignal den **ladungsbezogenen Spannungsgradienten (u_grad,q)** darstellt,
insbesondere wobei der Proportionalwert des weiteren Proportionalglieds der Kehrwert des Ladungsänderungsbetrags (q_1) ist,
insbesondere so dass der dem Totzeitglied zugeführte Wert der inneren Zellspannung (u_i,q) erst bei einer Änderung des Ausgangssignal (Q_Zähler) des Integrierglieds um mindestens den Ladungsänderungsbetrag (q_1) als Ausgangssignal weitergeleitet wird,
wobei der Ladungsänderungsbetrag (q_1) größer als die Diskretisierung (q_a) ist, insbesondere aber mindestens hundertmal kleiner als die Nennladekapazität der Zelle.

4. Verfahren nach einem der vorhergehenden Ansprüche,
**dadurch gekennzeichnet, dass**
das erste und zweite Halteglied vom ladungsdiskreten Abtastsignal gesteuert sind, so dass der jeweils gehaltene Wert jeweils gehalten wird, bis das Ausgangssignal (Q_Zähler) des Integrierglieds sich um mindestens eine Diskretisierungsstufe ändert.

5. Verfahren nach einem der vorhergehenden Ansprüche,
**dadurch gekennzeichnet, dass**
**die innere Zellspannung (u_i,q)** als Differenz zwischen der erfassten Spannung und dem Produkt aus einem Parameter, welcher den Innenwiderstand der Zelle darstellt, und dem Wert des erfassten Stroms bestimmt,
und/oder dass
**der ladungsbezogene Spannungsgradient (u_grad,q)** durch partielle Differentiation des Werteverlaufs der inneren Zellspannung (u_i,q) gebildet wird.

6. Verfahren nach einem der vorhergehenden Ansprüche,
**dadurch gekennzeichnet, dass**
im ersten Verfahrensschritt die Zelle ausgehend von verschiedenen Anfangsladezuständen jeweils entladen wird und dabei zu jedem Ladewert die innere Zellspannung und der ladungsbezogene Spannungsgradient bestimmt werden,
insbesondere so, dass jeweilige Dreiertupel bestimmt werden, wobei jedes Dreiertupel einen Ladewert, einen Wert der inneren Zellspannung und einen Wert des ladungsbezogenen Spannungsgradienten aufweist,
insbesondere wobei der Ladewert bestimmt wird, indem vom Anfangsladezustand das Ausgangssignal Q_Zähler subtrahiert wird.

7. Verfahren nach einem der vorhergehenden Ansprüche,
**dadurch gekennzeichnet, dass**
die Dreiertupel abhängig von ihrem Wert der inneren Zellspannung in Spannungsintervalle sortiert werden und nach dem Sortieren für jedes Spannungsintervall eine Interpolationsfunktion bestimmt wird, welche einem Wert des ladungsbezogenen Spannungsgradienten einen Ladungswert zuordnet
oder dass
mittels zweidimensionaler Interpolation (23) eine Interpolationsfunktion bestimmt wird, welche einem Wertepaar, bestehend aus einem Wert des ladungsbezogenen Spannungsgradienten und einem Wert der inneren Zellspannung, einen Ladungswert zuordnet.

8. Verfahren nach einem der vorhergehenden Ansprüche,
**dadurch gekennzeichnet, dass**
nach dem Bestimmen der jeweiligen Interpolationsfunktion Stützpunkte der Interpolationsfunktion bestimmt werden, so dass aus den Stützpunkten eine Wertetabelle (42) gebildet ist.

9. Verfahren nach einem der vorhergehenden Ansprüche,
**dadurch gekennzeichnet, dass**
im zweiten Verfahrensschritt Zwischenwerte durch Interpolation, insbesondere lineare Interpolation, bestimmt werden.

10. Verfahren nach einem der vorhergehenden Ansprüche,
**dadurch gekennzeichnet, dass**
die Dreiertupel abhängig von ihrem Ladungswert in verschiedene Gruppen einsortiert werden, wobei jeder Gruppe ein jeweiliger Bereich von Ladungswerten zugordnet ist,
wobei die Bereiche einander nicht überlappen,
wobei für jede Gruppe eine Interpolation (23) ausgeführt wird, daraus Stützpunkte bestimmt werden und somit eine jeweilige Wertetabelle (42) für jede Gruppe bestimmt wird,
wobei im zweiten Verfahrensschritt die zur Bestimmung des Ladezustands auszuwählende Wertetabelle (42) nach einem Entscheidungskriterium ausgewählt wird.

11. Verfahren **nach Anspruch 10,**
**dadurch gekennzeichnet, dass**
- das Entscheidungskriterium ist, ob die aktuell bestimmte innere Zellspannung (u_i,q) unter einem vorgegebenen Schwellwert liegt, insbesondere bei welchem unabhängig vom Ladezustand eine eindeutige Zuordnung zwischen dem Spannungsgradienten (U_grad,q) und dem Ladungszustand (Q_ist) besteht,
- oder dass mit allen Wertetabellen (42) Ladewerte bestimmt werden und beim Auswählen des Ladewerts als aktuellen Ladungszustand das Entscheidungskriterium ist, die betragsmäßig kleinste Abweichung zwischen dem aktuellen Schätzwert (Q_Schätzer) und dem jeweiligen Interpolationswert,
- oder dass das Entscheidungskriterium ist, ob die Abweichung zwischen dem aktuellen Schätzwert (Q_Schätzer) und den Interpolationswerten einen vorgegebenen Schwellwert überschreitet, wobei in diesem Fall die Summe aus Stützwert (Q_Stützung) und (Q_Zähler) ausgegeben wird.

12. Energiespeichersystem, aufweisend eine Energiespeicherzelle und eine Signalelektronik mit einem Mittel zur Erfassung der an der Zelle anliegenden Spannung und zur Erfassung des Stromes der Zelle,
wobei die Signalelektronik so konfiguriert ist, dass sie ein Verfahren nach einem der vorhergehenden Ansprüche ausführt.

## Claims

1. Method for determining the state of charge of an energy storage cell, in particular of an electrochemical energy store, wherein the voltage (U_cell) applied to the energy storage cell and the current (I_cell) supplied or taken up by the energy storage cell are detected,
**characterized in that**
in a first method step a value table (42), in particular a characteristic diagram, is created, which assigns a state of charge to an internal cell voltage and to a charge-related voltage gradient calculated on the basis of the internal cell voltage (u_i,q),
wherein in a second method step, chronologically after the first method step, from the respective currently determined internal cell voltage and the respective currently determined charge-related voltage gradient a state of charge is assigned by means of the value table (42), in particular the characteristic diagram,
wherein the detected values of the current of the cell are fed to an integral element, from the output signal (Q_counter) of which a charge-discrete sampling signal (d_q) is generated, in particular by means of a computer element that determines a modulo value,
wherein the value of the voltage applied to the cell is detected in a manner controlled by the charge-discrete sampling signal and is fed to a first hold element, from the output signal of which the output signal of a proportional element is subtracted in order to determine the internal cell voltage (u_i,q), wherein the value of the current of the cell supplied or taken up by the energy storage cell is detected in a manner controlled by the charge-discrete sampling signal and is fed to a second hold element, the output signal of which is fed as an input signal to the proportional element.

2. Method according to claim 1,
**characterized in that**
the proportional value of the proportional element is a parameter representing the internal resistance of the cell.

3. Method according to any one of the preceding claims, **characterized in that**
the value of the internal cell voltage (u_i,q) is fed as an input signal to a dead-time element, which is controlled by the charge-discrete sampling signal and the dead time of which is a charge change amount (q_1),
wherein the respective value of the internal cell voltage (u_i,q) is subtracted from the output signal of the dead-time element and the difference thus formed is fed as an input signal to a further proportional element, the output signal of the proportional element being fed to a delay element, in particular to a first-order delay element, the output signal of which represents the charge-related voltage gradient (u_grad,q),
in particular wherein the proportional value of the further proportional element is the reciprocal of the charge change amount (q_1),
in particular such that the value of the internal cell voltage (u_i,q) fed to the dead-time element is forwarded as an output signal only when the output signal (Q_counter) of the integral element changes by at least the charge change amount (q_1), wherein the charge change amount (q_1) is greater than the discretization (q_a) but in particular at least one hundred times smaller than the nominal charge capacity of the cell.

4. Method according to any one of the preceding claims, **characterized in that**
the first and second hold element are controlled by the charge-discrete sampling signal such that the respective value held is held in each case until the output signal (Q_counter) of the integral element changes by at least one discretization step.

5. Method according to any one of the preceding claims, **characterized in that**
the internal cell voltage (u_i,q) is determined as the difference between the detected voltage and the product of a parameter representing the internal resistance of the cell and the value of the detected current,
and/or **in that**
the charge-related voltage gradient (u_grad,q) is formed by partial differentiation of the value curve of the internal cell voltage (u_i,q).

6. Method according to any one of the preceding claims, **characterized in that**
in the first method step the cell is discharged starting from different initial states of charge in each case, and the internal cell voltage and the charge-related voltage gradient are determined for each charge value,
in particular such that respective 3-tuples are determined, each 3-tuple comprising a charge value, a value of the internal cell voltage and a value of the charge-related voltage gradient,
in particular wherein the charge value is determined by subtracting the output signal (Q_counter) from the initial state of charge.

7. Method according to any one of the preceding claims, **characterized in that**
the 3-tuples are sorted into voltage intervals as a function of their value of the internal cell voltage, and after the sorting an interpolation function is determined for each voltage interval, which assigns a charge value to a value of the charge-related voltage gradient,
or **in that**
by means of two-dimensional interpolation (23) an interpolation function is determined which assigns a charge value to a value pair consisting of a value of the charge-related voltage gradient and a value of the internal cell voltage.

8. Method according to any one of the preceding claims,
**characterized in that**,
once the respective interpolation function has been determined, support points of the interpolation function are determined such that a value table (42) is formed from the support points.

9. Method according to any one of the preceding claims, **characterized in that**
in the second method step intermediate values are determined by interpolation, in particular linear interpolation.

10. Method according to any one of the preceding claims,
**characterized in that**
the 3-tuples are sorted into different groups as a function of their charge value, a respective range of charge values being assigned to each group,
wherein the ranges do not overlap one another,
wherein, for each group, an interpolation (23) is carried out, support points are determined therefrom, and thus a respective value table (42) is determined for each group,
wherein, in the second method step, the value table (42) to be selected for determining the state of charge is selected according to a decision criterion.

11. Method according to claim 10,
**characterized in that**
- the decision criterion is whether the currently determined internal cell voltage (u_i,q) is below a predefined threshold value, in particular at which, regardless of the state of charge, there is an unambiguous association between the voltage gradient (U_grad,q) and the state of charge (Q_actual),
- or **in that** charge values are determined using all the value tables (42), and when selecting the charge value as the current state of charge the decision criterion is the absolute smallest deviation between the current estimated value (Q_estimator) and the respective interpolation value,
- or **in that** the decision criterion is whether the deviation between the current estimated value (Q_estimator) and the interpolation values exceeds a predefined threshold value, with the sum of support value (Q_support) and (Q_counter) being output in this case.

12. Energy storage system, comprising an energy storage cell and signal electronics including a means for detecting the voltage applied to the cell and for detecting the current of the cell,
wherein the signal electronics are configured such that they execute a method according to any one of the preceding claims.

## Revendications

1. Procédé de détermination de l'état de charge d'une cellule de stockage d'énergie, en particulier d'un accumulateur d'énergie électrochimique,
sachant qu'il s'opère une détection de la tension (U_Zelle) appliquée à la cellule de stockage d'énergie, et du courant (I_Zelle) fourni à ladite cellule de stockage d'énergie ou consommé par cette dernière,
**caractérisé par**
l'instauration, lors d'une première étape opératoire, d'une table de valeurs (42), notamment d'un champ de courbes caractéristiques qui attribue un état de charge à une tension interne de la cellule et à un gradient de tension rapporté à la charge et calculé sur la base de ladite tension interne (u_i, q) de la cellule,
sachant que, lors d'une seconde étape opératoire succédant à ladite première étape opératoire dans le temps, un état de charge est attribué au moyen de ladite table de valeurs (42), notamment dudit champ de courbes caractéristiques, sur la base de la tension interne de la cellule respectivement déterminée en mode instantané, et du gradient de tension rapporté à la charge et déterminé en mode instantané,
les valeurs détectées du courant de la cellule étant délivrées à un organe intégrateur à partir du signal de sortie (Q_Zähler) duquel un signal d'échantillonnage de charge discrète (d_q) est engendré, en particulier au moyen d'un organe de calcul déterminant une valeur modulo,
la valeur de la tension appliquée à la cellule de stockage d'énergie étant détectée, avec commande par le signal d'échantillonnage de charge discrète, puis délivrée à un premier organe de maintien du signal de sortie duquel le signal de sortie d'un organe proportionnel est retranché en vue de déterminer ladite tension interne (u_i, q) de la cellule,
la valeur du courant de la cellule, fourni à ladite cellule de stockage d'énergie ou consommé par celle-ci, étant détectée avec commande par ledit signal d'échantillonnage de charge discrète, puis délivrée à un second organe de maintien dont le signal de sortie est délivré audit organe proportionnel en tant que signal d'entrée.

2. Procédé selon la revendication 1,
**caractérisé par le fait que**
la valeur proportionnelle de l'organe proportionnel est un paramètre représentatif de la résistance interne de la cellule.

3. Procédé selon l'une des revendications précédentes,
**caractérisé par le fait que**
la valeur de la tension interne (u_i, q) de la cellule est délivrée, en tant que signal d'entrée, à un organe à temps mort commandé par le signal d'échantillonnage de charge discrète, dont le temps mort est une grandeur (q_1) de modification de la charge,
la valeur respective de ladite tension interne (u_i, q) de la cellule étant retranchée du signal de sortie dudit organe à temps mort, et la différence ainsi formée étant délivrée à un organe proportionnel supplémentaire, en tant que signal d'entrée, le signal de sortie dudit organe proportionnel étant délivré à un organe de temporisation, en particulier à un organe temporisateur de premier ordre dont le signal de sortie représente le gradient de tension (u_grad, q) rapporté à la charge,
sachant notamment que la valeur proportionnelle dudit organe proportionnel supplémentaire est la valeur inverse de ladite grandeur (q_1) de modification de la charge,
en particulier de façon telle que ladite valeur de la tension interne (u_i, q) de la cellule délivrée audit organe à temps mort soit transmise, en tant que signal de sortie, uniquement lorsque le signal de sortie (Q_Zähler) de l'organe intégrateur varie selon au moins ladite grandeur (q_1) de modification de la charge,
laquelle grandeur (q_1) de modification de la charge est supérieure à la discrétisation (q_a),
mais est, en particulier, au moins cent fois inférieure à la capacité de charge nominale de ladite cellule.

4. Procédé selon l'une des revendications précédentes,
**caractérisé par le fait que**
les premier et second organes de maintien sont commandés par le signal d'échantillonnage de charge discrète de façon telle que la valeur respective de maintien soit maintenue, à chaque fois, jusqu'à ce que le signal de sortie (Q_Zähler) de l'organe intégrateur varie d'au moins un échelon de discrétisation.

5. Procédé selon l'une des revendications précédentes,
**caractérisé par le fait que**
la tension interne (u_i, q) de la cellule est déterminée en tant que différence entre la tension détectée et le produit d'un paramètre, représentatif de la résistance interne de ladite cellule, et de la valeur du courant détecté ;
et/ou **par le fait que**
le gradient de tension (u_grad, q), rapporté à la charge, est formé par différenciation partielle du profil des valeurs de ladite tension interne (u_i, q) de la cellule.

6. Procédé selon l'une des revendications précédentes,
**caractérisé par le fait que**,
lors de la première étape opératoire, la cellule est respectivement déchargée à partir de différents états de charge initiaux, la tension interne de ladite cellule, et le gradient de tension rapporté à la charge, étant alors déterminés pour chaque valeur de charge,
en particulier de façon telle que des tuples triples respectifs soient déterminés, chaque tuple triple comportant une valeur de charge, une valeur de ladite tension interne de la cellule et une valeur dudit gradient de tension rapporté à la charge,
sachant notamment que ladite valeur de charge est déterminée en retranchant, de l'état de charge initial, le signal de sortie Q_Zähler.

7. Procédé selon l'une des revendications précédentes,
**caractérisé par le fait que**
les tuples triples sont répartis en des intervalles de tension, d'une manière dépendant de leur valeur de tension interne de la cellule, et une fonction d'interpolation, attribuant une valeur de charge à une valeur du gradient de tension rapporté à la charge, est déterminée pour chaque intervalle de tension à l'issue de la répartition ;
ou **par le fait**
**qu'**une fonction d'interpolation, déterminée au moyen d'une interpolation bidimensionnelle (23), attribue une valeur de charge à une paire de valeurs composée d'une valeur dudit gradient de tension, rapporté à la charge, et d'une valeur de ladite tension interne de la cellule.

8. Procédé selon l'une des revendications précédentes,
**caractérisé par le fait**
**qu'**à l'issue de la détermination de la fonction d'interpolation respective, des points d'étaiement de ladite fonction d'interpolation sont déterminés de façon telle qu'une table de valeurs (42) soit formée à partir desdits points d'étaiement.

9. Procédé selon l'une des revendications précédentes,
**caractérisé par le fait que**,
lors de la seconde étape opératoire, des valeurs intermédiaires sont déterminées par interpolation, notamment par interpolation linéaire.

10. Procédé selon l'une des revendications précédentes,
**caractérisé par le fait que**
les tuples triples sont classés en différents groupes, d'une manière dépendant de leur valeur de charge, une plage respective de valeurs de charge étant attribuée à chaque groupe,
les plages ne se chevauchant pas mutuellement,
sachant qu'il s'opère, pour chaque groupe, une interpolation (23) sur la base de laquelle des points d'étaiement sont déterminés, et qu'une table de valeurs (42) respective est ainsi déterminée pour chaque groupe,
sachant que, lors de la seconde étape opératoire, la table de valeurs (42), devant être sélectionnée en vue de la détermination de l'état de charge, est sélectionnée d'après un critère de décision.

11. Procédé selon la revendication 10,
**caractérisé par le fait que**
- le critère de décision consiste à savoir si la tension interne (u_i, q) de la cellule, déterminée en mode instantané, se situe en deçà d'une valeur de seuil préétablie en présence de laquelle il existe en particulier, indépendamment de l'état de charge, une assignation mutuelle univoque entre le gradient de tension (U_grad, q), rapporté à la charge, et l'état de mise en charge (Q_ist) ;
- ou **par le fait que** des valeurs de charge sont déterminées à l'aide de toutes les tables de valeurs (42) et, au cours de la sélection de la valeur de charge en tant qu'état instantané de mise en charge, ledit critère de décision est l'écart présentant la grandeur la plus faible possible entre la valeur estimative instantanée (Q_Schätzer) et la valeur d'interpolation respective ;
- ou **par le fait que** ledit critère de décision consiste à savoir si l'écart, entre ladite valeur estimative instantanée (Q_Schätzer) et les valeurs d'interpolation, excède une valeur de seuil préétablie, auquel cas la somme de la valeur d'étaiement (Q_Stützung) et de (Q_Zähler) est éditée.

12. Système d'accumulation d'énergie comprenant une cellule de stockage d'énergie et une électronique de signaux dotée d'un moyen dévolu à la détection de la tension appliquée à la cellule, et à la détection du courant de ladite cellule,
ladite électronique de signaux étant configurée de telle sorte qu'elle mette en oeuvre un procédé conforme à l'une des revendications précédentes.
